# EUROPÄISCHE PATENTSCHRIFT

(11) **EP 2 509 116 B1**
(45) Veröffentlichungstag und Bekanntmachung des Hinweises auf die Patenterteilung: **18.05.2016**
(21) Anmeldenummer: 12002416.1
(22) Anmeldetag: 03.04.2012
(51) Int. Cl.: H01L 31/048, G01R 31/40, G01R 1/04, H02S 50/10, H02S 40/34

(54) **Positionierungsvorrichtung, Anschlussanordnung und Prüfverfahren**
Positioning device, connection assembly and test method
Dispositif de positionnement, agencement de raccordement et procédé de contrôle

(30) Priorität: 08.04.2011 DE 102011016564
(43) Veröffentlichungstag der Anmeldung: 10.10.2012
(73) Patentinhaber: Yamaichi Electronics Deutschland GmbH, 85609 Aschheim-Dornach (DE)
(72) Erfinder: Quiter, Michael, 57482 Wenden (DE); Braun, Sven, 81377 München (DE); Eberle, Erwin, 80687 München (DE)
(74) Vertreter: Müller-Boré & Partner Patentanwälte PartG mbB

(56) Entgegenhaltungen:
- WO-A1-2009/122456
- DE-A1-102007 060 023
- DE-U1-202010 011 496
- DE-U1-202010 011 497

## Beschreibung

Die vorliegende Erfindung betrifft eine Positionierungsvorrichtung, eine Anschlußanordnung und ein Verfahren zum Prüfen eines Solarpaneels.

Herkömmliche Solarmodule zur Erzeugung elektrischer Energie aus Sonnenlicht umfassen eine oder mehrere einzelne Solarzellen. Je nach gewünschter, vom Solarmodul zur Verfügung zu stellenden Spannung und/oder Stromstärke können einzelne Solarzellen innerhalb eines Moduls auch parallel und/oder in Reihe geschaltet und damit zu einer oder mehreren Solarzellengruppen zusammengefaßt werden. Die Solarzellengruppen können zu einem flachen Solarmodul zusammengefaßt werden. Die elektrischen Anschlüsse der Solarzellengruppen des Solarmoduls werden herkömmlicherweise nach außen geführt.

Da die einzelnen Solarzellengruppen unterschiedlich hohe Spannungen erzeugen können, ist für jedes Solarmodul eine Anschlußelektronik notwendig. Solarpaneele umfassen daher neben dem Solarmodul in der Regel eine elektrische Solarpaneelanschlußdose mit zumindest zwei Kontaktvorrichtungen, wobei Strom über die Kontaktvorrichtungen fließen kann. Das mit der Solarpaneelanschlußdose versehene Solarmodul wird als Solarpaneel bezeichnet. Herkömmlicherweise kann eine Solarpaneelanschlußdose an einem Solarpaneel befestigt und beispielsweise mit zwei Anschlußkabeln zur Abgabe der erzeugten elektrischen Leistung versehen sein. Alternativ können an einem Solarpaneel aber auch zwei Solarpaneelanschlußdosen mit jeweils einem einzigen Anschlußkabel vorgesehen sein.

Da die Effizienz einzelner Solarpaneele Toleranzen unterliegen kann und/oder Fertigungsfehler auftreten können, werden Solarpaneele regelmäßig einzeln beim Hersteller geprüft. Hierbei wird, um die Leistung eines jeden Solarpaneels zu messen, ein Bestrahlungstest durchgeführt, wobei konventionell jedes einzelne Solarpaneel mit Licht, insbesondere Kunstlicht bestrahlt wird und die von dem Solarpaneel erzeugte elektrische Leistung über die Anschlußkabel der Solarpaneelanschlußdose gemessen wird.

Die Druckschrift DE 20 2010 011 496 U1 offenbart eine Positionierungs-vorrichtung für eine Solarpaneelanschlußdose gemäß dem Oberbegriff des Anspruchs 1.

Die Druckschriften und DE 20 2010 011 497 U1 und WO 2009/122 456 A1 offenbaren jeweils eine Vorrichtung, welche an den Anschlußkabeln einer Solarpaneelanschlußdose angebrachte Verbinder in Position hält.

Die Druckschrift DE 10 2007 060 023 A1 offenbart eine Solarpaneelanschlußdose mit zwei lösbar daran angebrachten Vorrichtungen, welche die an Anschlußkabeln angebrachte Verbinder in Position halten.

Es ist eine Aufgabe der Erfindung, in einfacher und effizienter Weise eine Prüfung, insbesondere eine automatische Prüfung, eines Solarmoduls bzw. eines Solarpaneels zu ermöglichen. Diese Aufgabe wird durch eine Positionierungsvorrichtung mit den Merkmalen des Anspruchs 1, eine Anschlußanordnung mit den Merkmalen des Anspruchs 8 und ein Verfahren zum automatischen Prüfen mit den Merkmalen des Anspruchs 9 gelöst. Bevorzugte Ausführungsformen sind Gegenstand der abhängigen Ansprüche.

### Anschlußdose gemäß einem Aspekt

Ein Aspekt der vorliegenden Erfindung betrifft eine Positionierungsvorrichtung für eine Solarpaneelanschlußdose umfassend:
-- zumindest einen Verbinder, welcher mit einem zuordenbaren komplementären Verbinder zumindest eines Anschlußkabels der Solarpaneelanschlußdose kontaktierbar ist,
-- zumindest einen Prüfkontakt, welcher mit einem zugeordneten des zumindest einen Verbinders elektrisch verbunden ist und welcher von außen kontaktierbar ist und
-- zumindest eine Fixiervorrichtung, um die Positionierungsvorrichtung lösbar an einem Gehäuse der Solarpaneelanschlußdose zu fixieren.
wobei die Positionierungsvorrichtung (1) im fixierten Zustand entlang einer Verlagerungsrichtung (V) relativ zur Solarpaneelanschlußdose verlagerbar ist.

Vorteilhafterweise ermöglicht die Positionierungsvorrichtung eine genaue, insbesondere vordefinierte Positionierung des zumindest einen Prüfkontakts, welcher mittels des zugeordneten Verbinders mit der Solarpaneelanschlußdose verbindbar ist. Die Positionierung kann relativ zur Solarpaneelanschlußdose erfolgen, wenn die Positionierungsvorrichtung an der Solarpaneelanschlußdose fixiert ist, bzw. relativ zum Solarpaneel erfolgen, wenn die Anordnung von Solarpaneelanschlußdose und Positionierungsvorrichtung an einem Solarmodul angeordnet sind, um ein Solarpaneel auszubilden. Besonders vorteilhaft ist der Prüfkontakt von außen kontaktierbar, beispielsweise manuell oder automatisch mittels eines Meßkontakts, der elektrisch mit einem Prüfgerät verbunden ist. Aufgrund der vordefinierten Position des zumindest einen Prüfkontaktes kann ein Prüfautomat jeden der zumindest einen Prüfkontakte automatisch anfahren und kontaktieren. Da die Position des zumindest einen Prüfkontakts nicht von der Anordnung der Anschlußkabel bzw. Verbinder der Solarpaneelanschlußdose abhängig ist, sondern lediglich von der Positionierungsvorrichtung, kann die Anpassung von unterschiedlichen Solarpaneelanschlußdosen an unterschiedliche Prüfautomaten vorteilhafterweise durch ein einfaches Wechseln der Positionierungsvorrichtung erfolgen.

Weiter vorteilhafterweise ist zumindest ein komplementärer Verbinder der Solarpaneelanschlußdose mit einem zugeordneten Verbinder der Positionierungsvorrichtung verbindbar, so daß Anschlußkabel zwischen der Solarpaneelanschlußdose und dem/der komplementären Verbinder in ihrer Lage fixierbar sind. Dies ist insbesondere beim Transport des Solarpaneels von Vorteil, da das/die Anschlußkabel sich nicht an anderen Gegenständen verfangen kann/können.

Da der zumindest eine Prüfkontakt von außen kontaktierbar ist, besteht das Risiko eines elektrischen Schlags, wenn der Prüfkontakt über den Verbinder, einen zugeordneten komplementären Verbinder und die Solarpaneelanschlußdose mit dem Solarmodul elektrisch verbunden ist, da das Solarmodul bei einer Bestrahlung mit Licht eine Spannung erzeugt, welche dann an dem zumindest einen Prüfkontakt anliegen kann. Vorteilhafterweise ist die Positionierungsvorrichtung, insbesondere nach einer Prüfung des Solarpaneels, von der Solarpaneelanschlußdose lösbar, so daß der Prüfkontakt entfernbar ist. Ein Benutzer des Solarpaneels ist daher vor einem elektrischen Schlag geschützt. Weiter vorteilhafterweise erfolgt das Lösen bzw. Entfernen der Positionierungsvorrichtung zerstörungsfrei, so daß die Positionierungsvorrichtung zusammen mit einer anderen Solarpaneelanschlußdose wiederverwendet werden kann.

Die Positionierungsvorrichtung umfaßt zumindest einen Verbinder, welcher mit einem zuordenbaren komplementären Verbinder der Solarpaneelanschlußdose kontaktiert werden kann. Mit anderen Worten können bevorzugt ein, zwei, drei, vier oder mehr Verbinder an der Positionierungsvorrichtung vorgesehen sein. Insbesondere ist der zumindest eine Verbinder dazu ausgelegt, die in der Photovoltaik verwendeten Gleichströme von mehr als 30 A zu leiten. Der zumindest eine Verbinder und der komplementäre Verbinder sind gegenstückig ausbildbar bzw. es kann der komplementäre Verbinder gegenstückig zu dem zugeordneten Verbinder ausgewählt sein bzw. es kann der zumindest eine Verbinder gegenstückig zu dem zugeordneten komplementären Verbinder ausgewählt sein. Dadurch kann der elektrische und mechanische Kontakt durch eine lösbare Steckverbindung hergestellt werden. Besonders bevorzugt ist die Steckverbindung wasser-, wasserdampf- und/oder luftdicht ausgeführt, beispielsweise um eine Korrosion des komplementären Verbinders zu verhindern.

Die Positionierungsvorrichtung umfaßt zumindest einen Prüfkontakt. Mit anderen Worten können bevorzugt ein, zwei, drei, vier oder mehr Prüfkontakte an der Positionierungsvorrichtung vorgesehen sein. Jeder Prüfkontakt ist elektrisch mit einem zugeordneten der zumindest einen Verbinder verbunden. Insbesondere kann jedem Prüfkontakt genau ein Verbinder - von einem oder mehreren Verbindern - zugeordnet sein. Weiter bevorzugt ist jedem Verbinder genau ein Prüfkontakt zugeordnet. Die elektrische Verbindung kann beispielsweise durch eine elektrische Leitung zwischen dem Prüfkontakt und einem Anschlußkontakt des zugeordneten Verbinders erfolgen. Vorzugsweise ist der Prüfkontakt mit dem Anschlußkontakt des zugeordneten Verbinders einstückig ausgebildet. Beispielsweise kann der Prüfkontakt und der Anschlußkontakt aus einem metallenen Stanzteil ausgebildet sein.

Der Prüfkontakt ist von außen kontaktierbar. Der Begriff "außen" bedeutet im Sinne der Anmeldung, daß der Prüfkontakt im betriebsgemäßen Gebrauch, das heißt wenn die Positionierungsvorrichtung an einer an einem Solarmodul befestigten Solarpaneelanschlußdose fixiert ist, unmittelbar mit einem Element kontaktiert werden kann, das nicht Teil des Solarpaneels, der Solarpaneelanschlußdose und/oder der Positionierungsvorrichtung ist und von diesem auch nicht umschlossen ist. Ein solches Element kann beispielsweise ein Meßkontakt bzw. eine Meßspitze sein. Insbesondere muß das Element durch eine Öffnung in der Wandung der Positionierungsvorrichtung geführt werden, um mit dem Prüfkontakt zu kontaktieren.

Der Begriff "Kontakt" beinhaltet in diesem Sinne insbesondere elektrischen und/oder mechanischen Kontakt, so daß der zumindest eine Prüfkontakt ausgelegt ist, einen elektrischen und/oder einen mechanischen Kontakt herzustellen, insbesondere mit einer Meßspitze bzw. einem Meßkontakt. Weiter bevorzugt kann der zumindest eine Prüfkontakt ausgebildet sein, um einen elektrischen Kontakt mit einem vorbestimmten maximalen Übergangswiderstand herzustellen. Dazu kann der zumindest eine Prüfkontakt ein Kontaktelement aufweisen, welches an einer Kontaktseite kontaktierbar ist und mit der entgegengesetzten Anlageseite an einem Widerlager anliegt, wobei das Widerlager insbesondere elektrisch isolierend ist. Dabei kann das Kontaktelement durch einen Meßkontakt entlang einer Andruckrichtung K mit einer vorbestimmten Andruckkraft beaufschlagbar sein, wobei die Andruckkraft durch das Widerlager aufgenommen wird.

Somit kann die Solarpaneelanschlußdose in einem automatisierten Verfahren mittels des zumindest einen Prüfkontakts mit einer externen Prüfeinrichtung verbunden werden. Dadurch kann besonders vorteilhafterweise ermöglicht werden, daß die Funktionsprüfung des Solarpaneels ebenfalls automatisiert durchführbar ist. Dies wird insbesondere dadurch ermöglicht, daß einem Prüfautomaten die vordefinierte Position des zumindest einen Prüfkontakts übergeben werden kann, wodurch dieser Prüfautomat den zumindest einen Prüfkontakt gezielt anfahren kann. Somit kann der Prüfautomat in einfacher Weise einen elektrischen Kontakt mit dem Prüfkontakt und weiter mit dem Solarmodul herstellen und die Funktionsprüfung durchführen, in dem er einen Stromfluß über den Prüfkontakt mißt und/oder eine Spannung mißt, die an dem Prüfkontakt anliegt.

Folglich kann vorteilhafterweise ein umständliches manuelles Kontaktieren und elektrisches Verbinden der Solarpaneelanschlußdose mit der Prüfeinrichtung vermieden werden. Daher kann mittels der Positionierungsvorrichtung und unabhängig von der Solarpaneelanschlußdose ein herkömmlicher zeit- und kostenintensiver Bestrahlungstest zur Funktionsprüfung eines Solarmoduls vermieden werden, wobei der herkömmliche Bestrahlungstest ein manuelles Anschließen der Solarpaneelanschlußdose an die Prüfeinrichtung umfaßt. Vielmehr kann der Bestrahlungstest automatisiert durchgeführt werden, da mittels der Positionierungsvorrichtung die Meßkontakte der Prüfeinrichtung mit den Prüfkontakten automatisch elektrisch kontaktierbar sind.

Die Positionierungsvorrichtung umfaßt zumindest eine Fixiervorrichtung, um die Positionierungsvorrichtung lösbar an einem Gehäuse der Solarpaneelanschlußdose zu fixieren.

Der Begriff "fixieren" bzw. "fixierbar" umfaßt im Sinne der Anmeldung eine reibschlüssige, kraftschlüssige und/oder formschlüssige Verbindbarkeit bzw. Verbindung zweier Teile, d.h. der Fixiervorrichtung der Positionierungsvorrichtung und einer komplementären Fixiervorrichtung der Solarpaneelanschlußdose. Dabei bewirkt der Reib-, Kraft- und/oder Formschluß, daß eine gegenseitige Verlagerung dieser zwei Teile nicht bzw. nur innerhalb der vorbestimmbaren Toleranzen erfolgt oder lediglich entlang einer oder zweier der drei Raumrichtungen oder eine weitere Verlagerung, d.h. ein Lösen der Fixierung, nur unter Aufbringen einer vorbestimmbaren Kraft oder durch Benutzen eines speziellen Werkzeugs erfolgen kann. Beispielsweise kann ein Element an einem anderen Element fixiert sein, indem entsprechende Glieder miteinander in Eingriff treten, insbesondere verrasten, usw. Insbesondere verhindert die Fixiervorrichtung ein räumliches Trennen der Positionierungsvorrichtung von der Solarpaneelanschlußdose, während ein Verlagern bzw. ein Verschieben der Positionierungsvorrichtung relativ zur Solarpaneelanschlußdose möglich sein kann, beispielsweise für den Fall, daß die Fixiervorrichtung in eine Nut der Solarpaneelanschlußdose eingreift und darin entlang der Längserstreckung der Nut verschiebbar ist.

Beispielsweise kann die Positionierungsvorrichtung durch eine Steckverbindung lösbar an dem Gehäuse der Solarpaneelanschlußdose fixiert sein. Insbesondere umfaßt die Fixiervorrichtung ein Rastelement, welches mit einem komplementären Rastelement des Gehäuses verrasten kann. Dazu ist das Rastelement bevorzugt rückstellfähig ausgebildet. Der Begriff "rückstellfähig" im Sinne der Anmeldung bedeutet in diesem Zusammenhang, daß das Rastelement durch Einwirkung einer äußeren Kraft verformbar ist, wobei sich die Verformung im wesentlichen vollständig zurückbildet, wenn die äußere Kraft nicht mehr wirkt. Das heißt, daß das Rastelement nach dem Wirken der äußeren Kraft im wesentlichen zu seiner ursprünglichen Gestalt zurückkehrt. Insbesondere ist das Rastelement elastisch verformbar. Bevorzugt ist das Rastelement derart ausgebildet und angeordnet, daß es beim Anordnen an dem Gehäuse entlang einer Betätigungsrichtung B rückstellfähig verformt wird und beim Erreichen einer Anordnungsposition im wesentlichen zu seiner ursprünglichen Gestalt zurückkehrt, um mit dem komplementären Rastelement des Gehäuses zu verrasten. Zum Entrasten ist das Rastelement entlang der Betätigungsrichtung B verformbar, bevorzugt lediglich mittels eines Werkzeugs.

### Bevorzugte Ausführungsformen der Positionierungsvorrichtung

Vorzugsweise ist der zumindest eine Prüfkontakt der Positionierungsvorrichtung in einer zugeordneten Prüfkontaktaufnahme angeordnet, in welche ein Meßkontakt entlang einer Einführrichtung E einführbar ist, um den Prüfkontakt zu kontaktieren. Vorteilhafterweise kann so das versehentliche Kontaktieren des Prüfkontakts durch einen Benutzer vermieden werden. Mit anderen Worten kann die Prüfkontaktaufnahme eine Öffnung ausweisen, wobei der aufgenommene Prüfkontakt vom Rand der Öffnung entlang der Einführrichtung E beabstandet angeordnet ist. Bevorzugt ist die Prüfkontaktaufnahme bzw. deren Öffnung derart dimensioniert, daß ein menschlicher Finger den zumindest einen Prüfkontakt nicht kontaktieren kann. Insbesondere weist die Prüfkontaktaufnahme bzw. deren Öffnung einen Durchmesser von weniger als 10 mm, bevorzugt weniger als 6 mm auf. Weiter bevorzugt ist der Abstand zwischen dem Prüfkontakt und dem nach außen gerichteten Rand der Prüfkontaktaufnahme größer als 10 mm.

Vorzugsweise ist der zumindest eine Verbinder der Positionierungsvorrichtung als steckerartiger oder buchsenartiger Verbinder ausgebildet. Ein buchsenartiger komplementärer Verbinder kann durch Stecken mit dem steckerartigen Verbinder kontaktiert bzw. verbunden werden. Entsprechend kann ein steckerartiger komplementärer Verbinder durch Stecken mit dem buchsenartigen Verbinder kontaktiert bzw. verbunden werden. Für den Fall, daß die Positionierungsvorrichtung zwei, drei oder mehr Verbinder aufweist, können sowohl steckerartige Verbinder als auch buchsenartige Verbinder vorgesehen sein. Besonders bevorzugt sind die Anschlußkontakte der steckerartigen und buchsenartigen Verbinder identisch. Dabei können die Anschlußkontakte in Abhängigkeit, ob diese in einem steckerartigen oder buchsenartigen Verbinder angeordnet sind, anders positioniert und/oder orientiert sein. Insbesondere sind die Anschlußkontakte mit einem zugeordneten Prüfkontakt einstückig ausgebildet, beispielsweise als Stanzteil.

Weiter vorzugsweise umfaßt die Positionierungsvorrichtung genau zwei Verbinder, wobei der erste Verbinder ein steckerartiger Verbinder ist und der zweite Verbinder ein buchsenartiger Verbinder ist. Vorteilhafterweise kann die Solarpaneelanschlußdose verpolungssicher mit den zugeordneten zwei Prüfkontakten der Positionierungsvorrichtung elektrisch verbunden werden.

Vorzugsweise weist die Positionierungsvorrichtung zumindest ein Handhabungselement auf, mit welchem die Positionierungsvorrichtung räumlich verlagerbar ist, insbesondere maschinell verlagerbar ist, beispielsweise durch einen Prüfautomaten. Das zumindest eine Handhabungselement ist derart ausgelegt, um mit einem komplementären Handhabungselement einer automatischen Prüfvorrichtung in Eingriff zu gelangen. Dazu kann das zumindest eine Handhabungselement als Ausnehmung bzw. Öffnung ausgebildet sein, in welche ein Vorsprung des komplementären Handhabungselement eingreifen kann. Alternativ kann das zumindest eine Handhabungselement als Vorsprung ausgebildet sein, welcher in eine Ausnehmung bzw. Öffnung des komplementären Handhabungselements eingreifen kann. Bevorzugt weist die Positionierungsvorrichtung zwei Handhabungselemente auf, wobei besonders bevorzugt beide Handhabungselemente Ausnehmungen sind. Weiter bevorzugt können beide Handhabungselemente Vorsprünge sein. Insbesondere kann aber auch ein Handhabungselement eine Ausnehmung und das andere Handhabungselement ein Vorsprung sein.

Handhabungselemente, die als Ausnehmung ausgebildet sind, können konisch geformt sein, so daß sich die Ausnehmung entlang der Handhabungselementeinführrichtung H verjüngt, in welche das komplementäre Handhabungselement einführbar ist. Entsprechend können Handhabungselemente, die als Vorsprung ausgebildet sind, derart konisch geformt sein, so daß sich der Vorsprung entgegen der Handhabungselementeinführrichtung H verjüngt. Vorteilhafterweise ist das Einführen der komplementären Handhabungselemente vereinfacht.

Die Positionierungsvorrichtung ist an dem Gehäuse der Solarpaneelanschlußdose bevorzugt derart fixiert, daß eine Verlagerung der Positionierungsvorrichtung eine entsprechende Verlagerung der Solarpaneelanschlußdose bewirkt. Mit anderen Worten sind Positionierungsvorrichtung und Solarpaneelanschlußdose und das an der Solarpaneelanschlußdose befestigte Solarmodul miteinander durch das Fixieren starr verbindbar bzw. verbunden. Vorteilhafterweise kann die Solarpaneelanschlußdose bzw. das Solarpaneel durch den Prüfautomaten verlagert werden. Insbesondere kann eine Verlagerung des Solarpaneels bereits beim Eingreifen des zumindest einen komplementären Handhabungselements in das zumindest eine Handhabungselement der Positionierungsvorrichtung erfolgen. Zum Beispiel ist das Solarpaneel dadurch für den Bestrahlungstest ausrichtbar.

Vorzugsweise ist die Fixiervorrichtung der Positionierungsvorrichtung im fixierten Zustand relativ zum Gehäuse der Solarpaneelanschlußdose verlagerbar. Weiter ist die Positionierungsvorrichtung an dem Gehäuse der Solarpaneelanschlußdose derart fixiert, daß die Positionierungsvorrichtung entlang einer Verlagerungsrichtung V relativ zu der Solarpaneelanschlußdose verlagerbar ist.

Vorteilhafterweise kann die Solarpaneelanschlußdose bzw. das Solarpaneel durch den Prüfautomaten entlang von Richtungen verlagert werden, die von der Verlagerungsrichtung V verschieden sind. Eine Verlagerung des Solarpaneels bereits beim Eingreifen des zumindest einen komplementären Handhabungselements kann verhindert werden, solange das Eingreifen eine Verschiebung der Positionierungsvorrichtung entlang der Verlagerungsrichtung V bewirkt. Eine Verschiebungsstrecke, um welche die Positionierungsvorrichtung entlang der Verlagerungsrichtung V verlagerbar ist kann beschränkt sein, beispielsweise mittels Anschlägen. Die Verschiebungsstrecke kann zwischen etwa 5 mm und etwa 200 mm, bevorzugt zwischen etwa 10 mm und etwa 100 mm, insbesondere etwa 50 mm betragen.

Mit anderen Worten sind Positionierungsvorrichtung und Solarpaneelanschlußdose, und das an der Solarpaneelanschlußdose befestigte Solarmodul, miteinander durch das Fixieren beweglich verbindbar bzw. verbunden. Beispielsweise ist die komplementäre Fixiervorrichtung als Führungsnut ausgebildet, in welche die Fixiervorrichtung eingreift, um entlang der Längserstreckung der Führungsnut entlang der Verlagerungsrichtung V relativ zu der Solarpaneelanschlußdose verlagerbar bzw. verschiebbar zu sein. Dagegen ist eine relative Verlagerung entlang der beiden senkrecht zur Verlagerungsrichtung V stehenden Richtungen gehemmt. Die komplementäre Fixiervorrichtung umfaßt bevorzugt zwei Anschläge, welche die relative Verlagerung der Positionierungsvorrichtung zur Solarpaneelanschlußdose beschränken, damit sich die Positionierungsvorrichtung nicht von der Solarpaneelanschlußdose löst. Es versteht sich, daß bei Fehlen entsprechender Anschläge der Prüfautomat auch zum Trennen von Positionierungsvorrichtung und Solarpaneelanschlußdose durch eine relative Verlagerung entlang der Verlagerungsrichtung V verwendet werden kann.

### Anschlußanordnung gemäß einem Aspekt

Ein Aspekt der vorliegenden Erfindung betrifft eine Anschlußanordnung für ein Solarmodul mit
- einer Solarpaneelanschlußdose umfassend:
   -- ein Gehäuse,
   -- zumindest ein Anschlußkabel, wobei das zumindest eine Anschlußkabel einen Verbinder aufweist, und
- einer erfindungsgemäßen Positionierungsvorrichtung.

Mit anderen Worten umfaßt die Solarpaneelanschlußdose ein Gehäuse und zumindest ein Anschlußkabel, wobei das zumindest eine Anschlußkabel einen Verbinder aufweist. Vorteilhafterweise ermöglicht die zumindest eine Positionierungsvorrichtung eine vordefinierte Positionierung des Prüfkontaktes und einen Schutz des zumindest einen komplementären Verbinders, welcher an dem Anschlußkabel der Solarpaneelanschlußdose angeordnet ist. Dadurch wird eine automatisierte elektrische Prüfung der Solarpaneelanschlußdose ermöglicht, wobei die Solarpaneelanschlußdose noch nicht mit einem Solarmodul verbunden sein muß. Weiter kann die Solarpaneelanschlußdose in einem automatisierten Verfahren an dem Solarmodul angeordnet und mit dieser verbunden werden, wobei die Positionierung vorteilhafterweise mittels der Positionierungsvorrichtung erfolgen kann. Anschließend kann besonders vorteilhafterweise ermöglicht werden, daß die Funktionsprüfung des dabei entstandenen Solarpaneels ebenfalls automatisiert durchführbar ist. Dies wird insbesondere dadurch ermöglicht, daß einem Prüfautomaten die vordefinierte Position der Prüfkontakt übergeben werden kann, wodurch dieser Prüfautomat den zumindest einen Prüfkontakt gezielt anfahren kann.

Die Solarpaneelanschlußdose kann an einer Anschlußseite bzw. -fläche eines Solarmoduls mittels der Positionierungsvorrichtung, insbesondere automatisch, anordenbar sein. Mit anderen Worten kann ein Montageautomat die Anschlußanordnung mittels der Positionierungsvorrichtung greifen und an dem Solarmodul zur Befestigung anordnen. Die "Anschlußseite bzw. -fläche" im Sinne der Erfindung beschreibt eine Seite bzw. Fläche, die insbesondere einer lichtaktiven Seite bzw. Fläche gegenüber liegt. Mit anderen Worten ist die lichtaktive Seite bzw. Fläche ausgelegt, Licht aufzunehmen bzw. in das Solarmodul zu führen. Die "Anschlußseite bzw. -fläche" ist insbesondere die Rückseite des Solarmoduls, mittels welcher das Solarmodul beispielsweise befestigt bzw. montiert werden kann.

Durch Anordnen und Befestigen der Solarpaneelanschlußdose bzw. der erfindungsgemäßen Anschlußanordnung wird ein Solarpaneel ausgebildet. Das Solarpaneel umfaßt daher ein Solarmodul, eine erfindungsgemäße Solarpaneelanschlußdose und eine erfindungsgemäße Positionierungsvorrichtung. Nach der Prüfung des Solarpaneels kann die Positionierungsvorrichtung, insbesondere zerstörungsfrei, entfernt werden. Mit anderen Worten ist die Positionierungsvorrichtung entfernbar bzw. lösbar an der Solarpaneelanschlußdose angeordnet bzw. befestigt. Entsprechend erlaubt die Verwendung einer erfindungsgemäßen Anschlußanordnung zur Anordnung an ein Solarmodul das Herstellen eines Solarpaneels.

Vorzugsweise ist jedem Verbinder der Positionierungsvorrichtung genau ein Anschlußkabel der Solarpaneelanschlußdose unvertauschbar zugeordnet. Vorteilhafterweise kann dadurch eine Verpolung, das heißt eine falsche Kontaktierung der Meßkontakte der externen Prüfeinrichtung mit den Prüfkontakten, bei der Prüfung des Solarpaneels ausgeschlossen werden.

### Prüfverfahren gemäß einem Aspekt

Ein Aspekt der vorliegenden Erfindung betrifft ein Verfahren zum automatischen Prüfen eines Solarpaneels mit den Schritten:
- Bereitstellen eines Solarpaneels, welches eine erfindungsgemäße Anschlußanordnung umfaßt;
- Kontaktieren zumindest eines Meßkontakts einer Prüfeinrichtung mit einem zugeordneten Prüfkontakt;
- Durchführen der Prüfung mittels der Prüfeinrichtung;
- Dekontaktieren des zumindest einen Meßkontakts.

Gemäß einer Ausführungsform ist der zugeordnete Prüfkontakt ein Prüfkontakt der Positionierungsvorrichtung der Anschlußanordnung. Dabei erfolgt das Kontaktieren bzw. das Dekontaktieren insbesondere automatisch, beispielsweise durch die Prüfeinrichtung bzw. einen Prüfautomaten. Zur Prüfung der Funktion des Solarpaneels wird an einem Prüfkontakt das anliegende elektrische Potential, der über den Prüfkontakt fließende Strom, die dort abgreifbare elektrische Leistung (z.B. bei der Bestrahlung des Solarpaneels mit Licht) oder ähnliches gemessen und mit Soll-Werten verglichen. Bei Abweichungen von den Soll-Werten wird dies dokumentiert und beispielsweise das geprüfte Solarpaneel als Ausschuß markiert.

Vorzugsweise umfaßt das Verfahren den zusätzlichen Schritt des Entfernens der Positionierungsvorrichtung. Vorteilhafterweise kann die Positionierungsvorrichtung zur Verwendung mit anderen Solarpaneelanschlußdosen vorgesehen sein, um mit diesen wieder eine erfindungsgemäße Anschlußanordnung auszubilden.

Vorzugsweise umfaßt das Verfahren den zusätzlichen Schritt des Positionierens der Positionierungsvorrichtung. Insbesondere erfolgt die Positionierung derart, daß ein vorbestimmter Kontaktierungsbereich eines der Prüfkontakte mit einem zugeordneten Meßkontakt elektrisch kontaktieren kann. Insbesondere kann die Positionierungsvorrichtung derart positioniert bzw. verlagert werden, daß die Meßkontakte entlang der Einführrichtung E in die Prüfkontaktaufnahme einführbar sind, um die zugeordneten Prüfkontakte zu kontaktieren. Weiter bevorzugt umfaßt das Positionieren der Positionierungsvorrichtung auch eine Positionierung bzw. Verlagerung der Solarpaneelanschlußdose bzw. des Solarpaneels, beispielsweise um das Solarpaneel für einen Bestrahlungstest bezüglich einer Lichtquelle auszurichten.

### Figurenbeschreibung

Nachfolgend wird eine bevorzugte Ausführungsform der vorliegenden Erfindung anhand der beigefügten Zeichnungen beispielhaft erläutert. Es zeigt:
- Figur 1:: eine perspektivische Ansicht einer Ausführungsform der Positionierungsvorrichtung;
- Figur 2:: eine Draufsicht auf die in Figur 1 gezeigte Positionierungsvorrichtung.

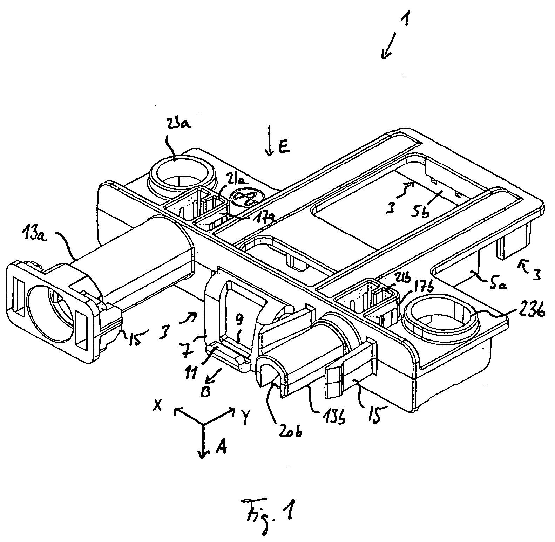

Figur 1 zeigt eine perspektivische Ansicht einer Ausführungsform einer Positionierungsvorrichtung 1 für eine Solarpaneelanschlußdose (nicht gezeigt). Die Positionierungsvorrichtung 1 umfaßt eine Fixiervorrichtung 3, mit welcher die Positionierungsvorrichtung 1 lösbar an einem Gehäuse der Solarpaneelanschlußdose fixierbar ist. Die Positionierungsvorrichtung 1 kann zum Anordnen an die Solarpaneelanschlußdose entlang einer Anordenrichtung A an das Gehäuse der Solarpaneelanschlußdose angeordnet werden. Beim Anordnen können Fixierelemente 5a, 5b derart mit dem Gehäuse in Eingriff gelangen, daß eine Verlagerung der Positionierungsvorrichtung 1 im angeordneten Zustand gehemmt ist. Ein in der Figur 1 gezeigtes erstes Fixierelement 5a hemmt beispielsweise eine Verlagerung entlang einer Breitenrichtung X, die senkrecht zur Anordenrichtung A steht. Ein in der Figur 1 gezeigtes zweites Fixierelement 5b hemmt beispielsweise eine Verlagerung entgegen einer Längsrichtung Y, die senkrecht zur Anordenrichtung A und senkrecht zur Breitenrichtung X steht. Entsprechende dritte und vierte Fixierelemente, welche eine Verlagerung der Positionierungsvorrichtung 1 entgegen der Breitenrichtung X und entlang der Längsrichtung Y hemmen sind an den gegenüberliegenden Seiten der Positionierungsvorrichtung 1 angeordnet und in der Figur 1 nicht sichtbar.

Um nach dem Anordnen der Positionierungsvorrichtung 1 an dem Gehäuse der Solarpaneelanschlußdose eine Verlagerung der Positionierungsvorrichtung 1 entgegen der Anordenrichtung A zu verhindern, umfaßt die Fixiervorrichtung 3 ein Rastelement 7. Das Rastelement 7 kann mit einem komplementären Rastelement (nicht gezeigt) des Gehäuses verrasten. Dazu ist das Rastelement 7 rückstellfähig ausgebildet. Beim Anordnen der Positionierungsvorrichtung 1 an das Gehäuse wird insbesondere ein Rastbereich 9 des Rastelements 7 entlang einer Betätigungsrichtung B verlagert. Nach dem korrekten Anordnen der Positionierungsvorrichtung 1, das heißt beim Erreichen der Anordnungsposition, kehrt das Rastelement 7 zu seiner ursprünglichen Gestalt zurück, wobei sich der Rastbereich 9 des Rastelements 7 entgegen der Betätigungsrichtung B verlagert, um mit einem komplementären Rastelement des Gehäuses der Solarpaneelanschlußdose zu verrasten. Zum Entrasten kann eine Kraft an einem Betätigungsbereich 11 des Rastelement 7 entlang der Betätigungsrichtung B angelegt werden, um den Rastbereich 9 entsprechend zu verlagern und die Verrastung aufzuheben. Danach kann die Positionierungsvorrichtung 1 durch eine Verlagerung der Positionierungsvorrichtung 1 entgegen der Anordenrichtung A von dem Gehäuse der Solarpaneelanschlußdose entfernt werden.

Die in Figur 1 gezeigte Positionierungsvorrichtung 1 umfaßt einen ersten Verbinder 13a und einen zweiten Verbinder 13b. Der erste Verbinder 13a ist als buchsenartiger Verbinder 13a und der zweite Verbinder 13b als steckerartiger Verbinder 13b ausgebildet. Der buchsenartige Verbinder 13a kann durch Stecken mit einem steckerartigen komplementären Verbinder (nicht gezeigt) der Solarpaneelanschlußdose kontaktiert bzw. verbunden werden. Entsprechend kann der steckerartiger Verbinder 13b mit einem buchsenartigen komplementären Verbinder (nicht gezeigt) der Solarpaneelanschlußdose kontaktiert werden. Vorteilhafterweise ist durch das Bereitstellen genau eines buchsenartigen Verbinders 13a und genau eines steckerartigen Verbinders 13b ein falsches Kontaktieren mit der Solarpaneelanschlußdose ausgeschlossen. Der erste und zweite Verbinder 13a, 13b sind jeweils ausgelegt, die in der Photovoltaik verwendeten Gleichströme von mehr als 30 A zu leiten.

Bevorzugt ermöglichen erster und zweiter Verbinder 13a, 13b zusammen mit den komplementären Verbindern eine wasserdichte Steckverbindung. Besonders bevorzugt weisen der erste Verbinder 13a und/oder der zweite Verbinder 13b Verbinderrastelemente 15 auf. Die Verbinderrastelemente 15 sind ausgelegt, um mit komplementären Verbinderrastelementen der komplementären Verbinder zu verrasten. Dadurch ist ein Lösen der Steckverbindung zwischen dem ersten Verbinder 13a und/oder dem zweiten Verbinder 13b mit den entsprechenden komplementären Verbindern der Solarpaneelanschlußdose erst nach dem Lösen der Verrastung möglich. Insbesondere ist das Lösen der Verrastung lediglich mittels eines Werkzeugs möglich.

Die in Figur 1 gezeigte Positionierungsvorrichtung 1 umfaßt eine erste Prüfkontaktaufnahme 17a und eine zweite Prüfkontaktaufnahme 17b. Ein Meßkontakt (nicht gezeigt) kann entlang einer Einführrichtung E in die erste Prüfkontaktaufnahme 17a bzw. die zweite Prüfkontaktaufnahme 17b eingeführt werden, um die darin befindlichen Prüfkontakte (in Figur 1 nicht zu sehen) zu kontaktieren.

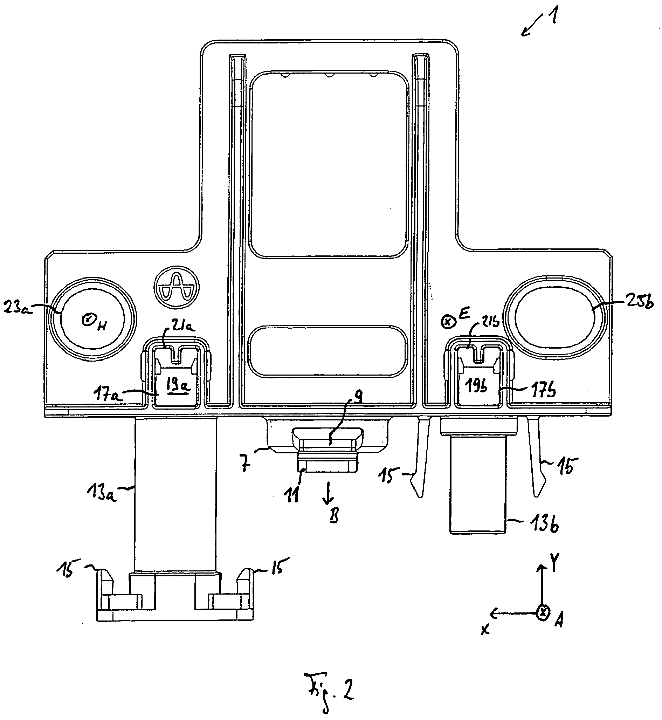

Figur 2 zeigt eine Draufsicht auf die in Figur 1 gezeigte Positionierungsvorrichtung 1, in welcher auch ein erster Prüfkontakt 19a und ein zweiter Prüfkontakt 19b gezeigt sind. Der erste Prüfkontakt 19a ist in der ersten Prüfkontaktaufnahme 17a angeordnet und mit dem ersten Verbinder 13a elektrisch verbunden. Der zweite Prüfkontakt 19b ist in der zweiten Prüfkontaktaufnahme 17b angeordnet und mit dem zweiten Verbinder 13b elektrisch verbunden. Die elektrische Verbindung kann beispielsweise durch eine elektrische Leitung zwischen dem Prüfkontakt 19b und einem Anschlußkontakt 20b (in Figur 1 gezeigt) des zugeordneten Verbinders 13b erfolgen. Besonders bevorzugt ist der Prüfkontakt 19b mit dem Anschlußkontakt 20b des zugeordneten Verbinders 13b einstückig ausgebildet.

Der erste Prüfkontakt 19a und der zweite Prüfkontakt 19b entsprechen dabei vorbestimmten Positionen an der Positionierungsvorrichtung 1. Mit anderen Worten ist die Position des ersten Prüfkontakts 19a durch eine zugehörige X-Koordinate X₁ und eine zugehörige Y-Koordinate Y₁ eindeutig definiert. Entsprechend ist die Position des zweiten Prüfkontakts 19b durch ein zugehöriges zweites Koordinatenpaar (X₂, Y₂) definiert. Der Ursprung des X-Y-Koordinatensystem kann ein beliebiger Punkt der Positionierungsvorrichtung 1 sein, beispielsweise die Position eines Handhabungselements 23a. Zur Kontaktierung des ersten Prüfkontakts 19a kann ein Prüfautomat einen zugeordneten ersten Meßkontakt (nicht gezeigt) an die Position mit den Koordinaten (X₁, Y₁) fahren, um den ersten Meßkontakt entlang der Einführrichtung E in die erste Prüfkontaktaufnahme 17a einzuführen und den ersten Prüfkontakt 19a zu kontaktieren. Analog kann zur Kontaktierung des zweiten Prüfkontakts 19b ein zugeordneter zweiter Meßkontakt (nicht gezeigt) an die Position mit den Koordinaten (X₂, Y₂) gefahren werden, um den zweiten Meßkontakt entlang der Einführrichtung E in die zweite Prüfkontaktaufnahme 17b einzuführen und den zweiten Prüfkontakt 19b zu kontaktieren. Dabei können der erste und zweite Meßkontakt eine Andruckkraft auf die zugeordneten Prüfkontakte 19a, 19b entlang der Einführrichtung E anlegen.

Der erste Prüfkontakt und der zweite Prüfkontakt ist von außen kontaktierbar, in diesem Fall durch das Einführen eines zugeordneten Meßkontakts. Um das Risiko eines elektrischen Schlags für Benutzer zu vermindern, weisen die ersten Prüfkontaktaufnahme 17a und die zweite Prüfkontaktaufnahme 17b entlang der Längsrichtung Y bzw. der Breitenrichtung X eine Erstreckung von weniger als 10 mm, bevorzugt von weniger als 5 mm auf. Weiter bevorzugt beträgt der Abstand von dem ersten Prüfkontakt 19a zum Rand 21a der ersten Prüfkontaktaufnahme 17a entlang der Einführrichtung E mehr als 5 mm, insbesondere mehr als 10 mm. Entsprechend bemessen ist auch der Abstand von dem zweiten Prüfkontakt 19b zum Rand 21 b der zweiten Prüfkontaktaufnahme 17b entlang der Einführrichtung E.

Die in den Figuren 1 und 2 gezeigte Positionierungsvorrichtung 1 umfaßt ein erstes Handhabungselement 23a und ein zweite Handhabungselement 23b, mit welchen die Positionierungsvorrichtung 1 räumlich entlang der Längsrichtung Y und der Breitenrichtung X verlagerbar ist. Die Handhabungselemente 23a, 23b sind als Ausnehmung bzw. Öffnung ausgebildet, in welche jeweils ein zugeordneter Vorsprung des Prüfautomaten entlang einer Handhabungselementeeinführrichtung H eingreifen kann. Bevorzugt ist die Handhabungselementeeinführrichtung H parallel zur Einführrichtung E.

### Bezugszeichenliste

- 1: Positionierungsvorrichtung
- 3: Fixiervorrichtung
- 5a, 5b: Fixierelement
- 7: Rastelement
- 9: Rastbereich
- 11: Betätigungsbereich
- 13a, 13b: Verbinder
- 15: Verbinderrastelement
- 17a, 17b: Prüfkontaktaufnahme
- 19a, 19b: Prüfkontakt
- 20b: Anschlußkontakt
- 21a, 21b: Rand der Prüfkontaktaufnahme
- 23a, 23b: Handhabungselement
- A: Anordenrichtung
- B: Betätigungsrichtung
- E: Einführrichtung
- X: Breitenrichtung
- Y: Längsrichtung

## Patentansprüche

1. Positionierungsvorrichtung (1) für eine Solarpaneelanschlußdose umfassend:
-- zumindest einen Verbinder (13a, 13b), welcher mit einem zuordenbaren komplementären Verbinder zumindest eines Anschlußkabels der Solarpaneelanschlußdose kontaktierbar ist,
-- zumindest einen Prüfkontakt (19a, 19b), welcher mit einem zugeordneten Verbinder (13a, 13b) elektrisch verbunden ist und welcher von außen kontaktierbar ist,
**gekennzeichnet durch**
-- zumindest eine Fixiervorrichtung (3, 5a, 5b), um die Positionierungsvorrichtung (1) lösbar an einem Gehäuse der Solarpaneelanschlußdose zu fixieren,
wobei die Positionierungsvorrichtung (1) im fixierten Zustand entlang einer Verlagerungsrichtung (V) relativ zur Solarpaneelanschlußdose verlagerbar ist.

2. Positionierungsvorrichtung (1) nach Anspruch 1, wobei der zumindest eine Prüfkontakt (19a, 19b) in einer zugeordneten Prüfkontaktaufnahme (17a, 17b) angeordnet ist, in welche ein Meßkontakt entlang einer Einführrichtung (E) einführbar ist, um den Prüfkontakt (19a, 19b) zu kontaktieren.

3. Positionierungsvorrichtung (1) nach Anspruch 1 oder 2, wobei der zumindest eine Verbinder (13a, 13b) als steckerartiger oder buchsenartiger Verbinder ausgebildet ist.

4. Positionierungsvorrichtung (1) nach Anspruch 3 mit zwei Verbindern (13a, 13b), wobei ein erster Verbinder (13b) ein steckerartiger Verbinder ist und ein zweiter Verbinder (13a) ein buchsenartiger Verbinder ist.

5. Positionierungsvorrichtung (1) nach einem der vorigen Ansprüche, wobei jeder Prüfkontakt (19b) mit einem Anschlußkontakt (20b) des zugeordneten Verbinders (13b) einstückig ausgebildet ist.

6. Positionierungsvorrichtung (1) nach einem der vorigen Ansprüche, wobei die Positionierungsvorrichtung (1) zumindest ein Handhabungselement (23a, 23b) aufweist, mit welchem die Positionierungsvorrichtung (1) räumlich verlagerbar ist.

7. Positionierungsvorrichtung (1) nach einem der vorigen Ansprüche, wobei die Positionierungsvorrichtung (1) um eine Verschiebungsstrecke von etwa 5 mm bis etwa 200 mm entlang der Verlagerungsrichtung (V) verlagerbar ist.

8. Anschlußanordnung für ein Solarmodul mit
- einer Solarpaneelanschlußdose umfassend:
-- ein Gehäuse,
-- zumindest ein Anschlußkabel, wobei das zumindest eine Anschlußkabel einen Verbinder aufweist, und
- einer Positionierungsvorrichtung (1) gemäß einem der vorigen Ansprüche.

9. Verfahren zum automatischen Prüfen eines Solarpaneels mit den Schritten:
- Bereitstellen eines Solarpaneels, welches eine Anschlußanordnung gemäß Anspruch 8 umfaßt;
- Kontaktieren zumindest eines Meßkontakts einer Prüfeinrichtung mit einem zugeordneten Prüfkontakt der Positionierungsvorrichtung (1) der Anschlußanordnung;
- Durchführen der Prüfung mittels der Prüfeinrichtung;
- Dekontaktieren des zumindest einen Meßkontakts.

10. Verfahren nach Anspruch 9 mit dem zusätzlichen Schritt:
- Entfernen der Positionierungsvorrichtung (1).

11. Verfahren nach Anspruch 9 oder 10 mit dem zusätzlichen Schritt:
- Positionieren der Positionierungsvorrichtung (1).

## Claims

1. A positioning device (1) for a solar panel junction box, comprising:
- at least one connector (13a, 13b) that can be contacted with an assignable, complementary connector of at least one connection cable of the solar panel junction box,
- at least one test contact (19a, 19b) that is electrically connected to an assigned connector (13a, 13b) and that can be contacted from outside,
**characterized by**
- at least one fixation device (3, 5a, 5b) to releasably fix the positioning device (1) to a housing of the solar panel junction box,
wherein in the fixed state, the positioning device (1) can be displaced along a displacement direction (V) relative to the solar panel junction box.

2. The positioning device (1) according to claim 1, wherein the at least one test contact (19a, 19b) is arranged in an assigned test contact receptacle (17a, 17b) into which a measuring contact is insertable along an insertion direction (E) in order to contact the test contact (19a, 19b).

3. The positioning device (1) according to claim 1 or 2, wherein the at least one connector (13a, 13b) is formed as a plug-like or socket-like connector.

4. The positioning device (1) according to claim 3 with two connectors (13a, 13b), wherein a first connector (13b) is a plug-like connector and a second connector (13a) is a socket-like connector.

5. The positioning device (1) according to one of the preceding claims, wherein each test contact (19b) is formed integrally with a terminal contact (20b) of the assigned connector (13b).

6. The positioning device (1) according to one of the preceding claims, wherein the positioning device (1) comprises at least one handling element (23a, 23b) with which the positioning device (1) can be displaced spatially.

7. The positioning device (1) according to one of the preceding claims, wherein the positioning device (1) can be displaced by a shift distance of about 5 mm to about 200 mm along the displacement direction (V).

8. A terminal assembly for a solar module, with
- a solar panel junction box, comprising:
-- a housing,
-- at least one connection cable, wherein the at least one connection cable includes a connector, and
- a positioning device (1) according to one of the preceding claims.

9. A method for automatically testing a solar panel, with the steps of:
- providing a solar panel that comprises a terminal assembly according to claim 8;
- contacting at least one measuring contact of a test device with an assigned test contact of the positioning device (1) of the terminal assembly;
- conducting the test by means of the test device;
- decontacting the at least one measuring contact.

10. The method according to claim 9, with the additional step of:
- removing the positioning device (1).

11. The method according to claim 9 or 10, with the additional step of:
- positioning the positioning device (1).

## Revendications

1. Dispositif de positionnement (1) pour une prise de courant de panneau solaire comprenant :
-- au moins un connecteur (13a, 13b) qui peut être contacté par un connecteur complémentaire pouvant être associé d'au moins un câble de raccordement de la prise de courant de panneau solaire,
-- au moins un contact de contrôle (19a, 19b) qui est relié électriquement à un connecteur associé (13a, 13b) et qui peut être contacté de l'extérieur,
**caractérisé par**
-- au moins un dispositif de fixation (3, 5a, 5b) pour fixer le dispositif de positionnement (1) de manière amovible sur un logement de la prise de courant de panneau solaire,
dans lequel le dispositif de positionnement (1) peut être déplacé à l'état fixé le long d'une direction de déplacement (V) par rapport à la prise de courant de panneau solaire.

2. Dispositif de positionnement (1) selon la revendication 1, dans lequel l'au moins un contact de contrôle (19a, 19b) est disposé dans un logement de contact de contrôle associé (17a, 17b) dans lequel un contact de mesure peut être introduit le long d'une direction d'introduction (E) pour contacter le contact de contrôle (19a, 19b).

3. Dispositif de positionnement (1) selon la revendication 1 ou 2, dans lequel l'au moins un connecteur (13a, 13b) est réalisé en tant que connecteur de type fiche mâle ou de type prise femelle.

4. Dispositif de positionnement (1) selon la revendication 3 avec deux connecteurs (13a, 13b), dans lequel un premier connecteur (13b) est un connecteur de type fiche mâle et un second connecteur (13a) est un connecteur de type prise femelle.

5. Dispositif de positionnement (1) selon une des revendications précédentes, dans lequel chaque contact de contrôle (19b) est réalisé d'une pièce avec un contact de raccordement (20b) du connecteur associé (13b).

6. Dispositif de positionnement (1) selon une des revendications précédentes, dans lequel le dispositif de positionnement (1) présente au moins un élément de maniement (23a, 23b) avec lequel le dispositif de positionnement (1) peut être déplacé dans l'espace.

7. Dispositif de positionnement (1) selon une des revendications précédentes, dans lequel le dispositif de positionnement (1) peut être déplacé d'un trajet de coulissement d'environ 5 mm à environ 200 mm le long de la direction de déplacement (V).

8. Agencement de raccordement pour un module solaire avec
- une prise de courant de panneau solaire comprenant :
-- un logement,
-- au moins un câble de raccordement, dans lequel l'au moins un câble de raccordement présente un connecteur, et
- un dispositif de positionnement (1) selon une des revendications précédentes.

9. Procédé de contrôle automatique d'un panneau solaire avec les étapes :
- mise à disposition d'un panneau solaire qui comprend un agencement de raccordement selon la revendication 8 ;
- établissement d'un contact d'au moins un contact de mesure d'un dispositif de contrôle avec un contact de contrôle associé du dispositif de positionnement (1) de l'agencement de raccordement ;
- réalisation du contrôle au moyen du dispositif de contrôle ;
- séparation du contact de l'au moins un contact de mesure.

10. Procédé selon la revendication 9 avec l'étape supplémentaire :
- retrait du dispositif de positionnement (1).

11. Procédé selon la revendication 9 ou 10 avec l'étape supplémentaire :
- positionnement du dispositif de positionnement (1).
